# EUROPEAN PATENT APPLICATION

(11) **EP 4 344 381 A1**
(43) Date of publication of application: **27.03.2024**
(21) Application number: 23191698.2
(22) Date of filing: 16.08.2023
(51) Int. Cl.: H10B 43/27

(54) **SEMICONDUCTOR DEVICES AND DATA STORAGE SYSTEMS INCLUDING THE SAME**

(30) Priority: 23.09.2022 KR 20220121006
(71) Applicant: Samsung Electronics Co., Ltd., Suwon-si, Gyeonggi-do 16677 (KR)
(72) Inventor: CHUNG, Sunghee, 16677 Suwon-si (KR); KIM, Hyeongjin, 16677 Suwon-si (KR); SHIN, Joongshik, 16677 Suwon-si (KR); HAN, Jeehoon, 16677 Suwon-si (KR)
(74) Representative: Marks & Clerk LLP

(57) **Abstract**

A semiconductor device (100) includes a source structure (SS) including a plate layer (101) and first and second horizontal conductive layers (102, 104) stacked in order on the plate layer (101), gate electrodes (130) stacked and spaced apart from each other in a first direction perpendicular to an upper surface of the source structure (SS), a channel structure (CH) penetrating through the gate electrodes (130), extending in the first direction, and including a channel layer in contact with the first horizontal conductive layer (102), and a separation region (MS) penetrating through the gate electrodes (130) and extending in the first direction and in a second direction perpendicular to the first direction, wherein the first horizontal conductive layer (102) extends horizontally below the separation region (MS) and has a seam (SE) overlapping the separation region (MS) in the first direction.

## Description

### BACKGROUND

### 1. Field

Example embodiments of the present disclosure relate to a semiconductor device and a data storage system including the same.

### 2. Description of the Related Art

A semiconductor device able to store high-capacity data in a data storage system requiring data storage has been necessary. Accordingly, a method for increasing data storage capacity of a semiconductor device has been researched.

### SUMMARY

Embodiments are directed to a semiconductor device. The semiconductor device includes a source structure including a plate layer and first and second horizontal conductive layers stacked in order on the plate layer, gate electrodes stacked and spaced apart from each other in a first direction perpendicular to an upper surface of the source structure, and a channel structure penetrating through the gate electrodes, extending in the first direction and including a channel layer in contact with the first horizontal conductive layer. The semiconductor device includes a separation region penetrating through the gate electrodes and extending in the first direction and in a second direction perpendicular to the first direction. The first horizontal conductive layer extends horizontally below the separation region and has a seam overlapping the separation region in the first direction.

Embodiments are also directed to a semiconductor device. The semiconductor device may include a source structure including a plate layer and a horizontal conductive layer on the plate layer, gate electrodes stacked and spaced apart from each other in a first direction perpendicular to an upper surface of the source structure, and a channel structure penetrating through the gate electrodes and extending in the first direction, and including a channel layer in contact with the horizontal conductive layer. The semiconductor device may include a separation region penetrating through the gate electrodes and extending in the first direction and in a second direction perpendicular to the first direction. The horizontal conductive layer may have a lower protrusion overlapping the separation region in the first direction and protruding into the plate layer from a lower surface of the horizontal conductive layer.

Embodiments are also directed to a data storage system. The data storage system may include a semiconductor storage device including a substrate, circuit devices on the substrate, lower interconnection lines on the circuit devices, and input/output pads electrically connected to the circuit devices. The semiconductor device may include a controller electrically connected to the semiconductor storage device through the input/output pad and configured to control the semiconductor storage device. The semiconductor storage device may further include a source structure including a plate layer and a horizontal conductive layer on the plate layer, gate electrodes stacked and spaced apart from each other in a first direction perpendicular to an upper surface of the source structure, and a channel structure penetrating through the gate electrodes, extending in the first direction, and including a channel layer in contact with the horizontal conductive layer. The semiconductor storage device may include a separation region penetrating through the gate electrodes and extending in the first direction and in a second direction perpendicular to the first direction. The horizontal conductive layer may extend horizontally below the separation region to overlap the separation region in the first direction.

At least some of the above and other features of the invention are set out in the claims.

### BRIEF DESCRIPTION OF DRAWINGS

Features will become apparent to those of skill in the art by describing in detail embodiments of the invention with reference to the attached drawings in which:
FIG. 1 is a plan view illustrating a semiconductor device according to an example embodiment.
FIG. 2 is a cross-sectional view illustrating a semiconductor device according to an example embodiment.
FIG. 3 is an enlarged view illustrating a portion of a semiconductor device according to an example embodiment.
FIGS. 4A to 4C are enlarged views illustrating a portion of a semiconductor device according to an example embodiment.
FIGS. 5A and 5B are a cross-sectional view illustrating a semiconductor device and an enlarged view illustrating a portion of a semiconductor device according to an example embodiment.
FIG. 6 is a cross-sectional view illustrating a semiconductor device according to an example embodiment.
FIG. 7 is a cross-sectional view illustrating a semiconductor device according to an example embodiment.
FIGS. 8, 9, 10A, 10B, 11A, 11B, 12A, 12B, 13A, 13B, and 14 are cross-sectional views illustrating a method of manufacturing a semiconductor device according to an example embodiment.
FIGS. 15A to 15E are cross-sectional views illustrating a method of manufacturing a semiconductor device according to an example embodiment.
FIG. 16 is a view illustrating a data storage system including a semiconductor device according to an example embodiment.
FIG. 17 is a perspective view illustrating a data storage system including a semiconductor device according to an example embodiment.
FIG. 18 is a cross-sectional view illustrating a semiconductor package according to an example embodiment.

### DETAILED DESCRIPTION

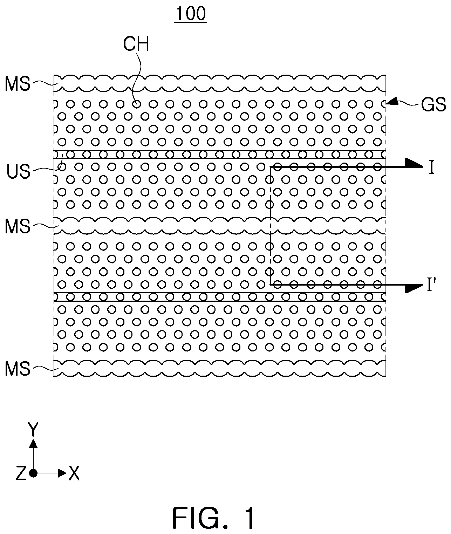

FIG. 1 is a plan view illustrating a semiconductor device according to an example embodiment.

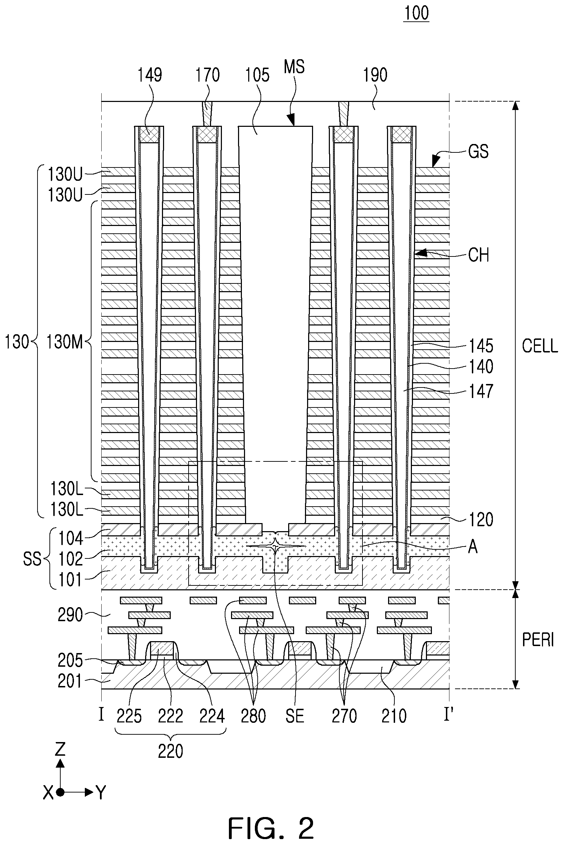

FIG. 2 is a cross-sectional view illustrating a semiconductor device according to an example embodiment, taken along line I-I' in FIG. 1.

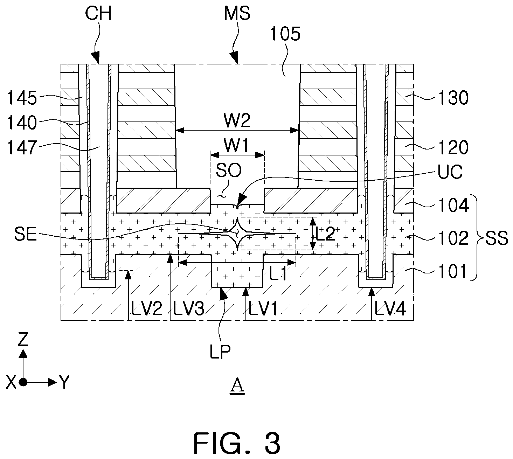

FIG. 3 is an enlarged view illustrating a portion of a semiconductor device according to an example embodiment, illustrating region "A" in FIG. 2.

Referring to FIGS. 1 to 3, the semiconductor device 100 may include a peripheral circuit region PERI, which is a first semiconductor structure including a substrate 201, and a memory cell region CELL, which is a second semiconductor structure including a source structure SS. The memory cell region CELL may be on the peripheral circuit region PERI. Alternately, in example embodiments, the memory cell region CELL may be below the peripheral circuit region PERI.

The peripheral circuit region PERI may include the substrate 201, impurity regions 205 and device isolation layers 210 in the substrate 201, circuit devices 220 on the substrate 201, a peripheral region insulating layer 290, lower contact plugs 270, and lower interconnection lines 280.

The substrate 201 may have an upper surface extending in x and y-directions. An active region may be defined on the substrate 201 by device isolation layers 210. The impurity regions 205 containing impurities may be in a portion of the active region. The substrate 201 may include a semiconductor material, such as a Group IV semiconductor, a Group III-V compound semiconductor, or a Group II-VI compound semiconductor. The substrate 201 may also be provided as a bulk wafer, an epitaxial layer, a silicon on insulator (SOI) layer, or a semiconductor on insulator (SeOl) layer.

The circuit devices 220 may include a planar transistor. Each of the circuit devices 220 may include a circuit gate dielectric layer 222, a spacer layer 224 and a circuit gate electrode 225. The impurity regions 205 may be disposed as source/drain regions in the substrate 201 on both sides of the circuit gate electrode 225.

The peripheral region insulating layer 290 may be on the circuit device 220 on the substrate 201. The peripheral region insulating layer 290 may include a plurality of insulating layers. The peripheral region insulating layer 290 may be formed of an insulating material.

The lower contact plugs 270 and the lower interconnection lines 280 may form a lower interconnection structure electrically connected to the circuit devices 220 and the impurity regions 205. The lower contact plugs 270 may have a cylindrical shape, and the lower interconnection lines 280 may have a line shape. Each of the lower contact plugs 270 and the lower interconnection lines 280 may include a conductive material, e.g., tungsten (W), copper (Cu), aluminum (Al), and may further include a diffusion barrier. However, in example embodiments, the number of layers of the lower contact plugs 270 and the lower interconnection lines 280 and arrangement thereof may be varied.

The memory cell region CELL may include a source structure SS, gate electrodes 130 stacked on the source structure SS, interlayer insulating layers 120 alternately stacked with the gate electrodes 130 on the source structure SS, channel structures CH disposed to penetrate through the stack structure GS of the gate electrodes 130 and each including a channel layer 140, upper separation regions US penetrating a portion of the stack structure GS, separation regions MS extending by penetrating through the stack structure GS, contact plugs 170 on the channel structures CH, and a cell region insulating layer 190 covering the gate electrodes 130 and the channel structures CH.

In the memory cell region CELL, a memory cell string may be formed around each channel structure CH, and a plurality of memory cell strings may be arranged in rows and columns in the x and y-directions.

The source structure SS may include a plate layer 101 and first and second horizontal conductive layers 102 and 104 on the plate layer 101. The source structure SS may function as a common source line of the semiconductor device 100.

The plate layer 101 may have upper surfaces extending in the x and y-directions. The plate layer 101 may include e.g., a doped semiconductor material, a metal material, or a metal-semiconductor compound (e.g., silicide). The plate layer 101 may be provided with a polycrystalline semiconductor layer such as a polycrystalline silicon layer or an epitaxial layer. As used herein, the term "or" is not an exclusive term, e.g., "A or B" would include A, B, or A and B.

The first and second horizontal conductive layers 102 and 104 may be stacked in order on the upper surface of the plate layer 101. The first horizontal conductive layer 102 may horizontally extend between the plate layer 101 and the second horizontal conductive layer 104. As illustrated in FIG. 3, the first horizontal conductive layer 102 may be directly connected to the channel layer 140 around the channel layer 140. The first horizontal conductive layer 102 may partially extend vertically along the channel layer 140 and may be in contact with the channel layer 140. The first horizontal conductive layer 102 may horizontally extend below the separation region MS. The first horizontal conductive layer 102 may overlap the separation region MS in a vertical direction, e.g., in the z-direction. A portion of the upper surface of the first horizontal conductive layer 102 may be in contact with the lower surface of the separation region MS, e.g., the lowermost surface.

As illustrated in FIG. 3, the first horizontal conductive layer 102 may have a lower protrusion LP extending from the lower surface and protruding into the plate layer 101. The lower protrusion LP may be in a region perpendicularly overlapping the separation region MS. Side surfaces of the lower protrusion LP may be on an extension line from side surfaces of the opening SO of the second horizontal conductive layer 104.

The first horizontal conductive layer 102 may partially extend upwardly through the opening SO and may partially cover side surfaces of the second horizontal conductive layer 104 exposed through the opening SO. However, in some example embodiments, the first horizontal conductive layer 102 may not extend into the opening SO. The first horizontal conductive layer 102 may have an upper curved portion UC on an upper surface and curved downwardly toward the plate layer 101, in the opening SO. The upper curved portion UC may be on a center of the opening SO in the y-direction or in a region adjacent to the center.

The first horizontal conductive layer 102 may have a seam SE therein. The seam SE may be referred to as a void and may be an air region. At least a portion of the seam SE may be disposed to vertically overlap the separation region MS. The seam SE may be horizontally spaced apart from the channel layers 140. In the example embodiment, the shim SE may have a first length L1 in the y-direction and a second length L2 smaller than the first length L1 in the z-direction. However, the specific shape of the shim SE may be varied in the example embodiments.

The lower surface of the first horizontal conductive layer 102 may be on a plurality of levels. As illustrated in FIG. 3, a lower end of the lower protrusion LP may be on a first level LV1, and a lower end region in contact with the channel layer 140 may be on a second level LV2 higher than the first level LV1, and a lower surface of the first horizontal conductive layer 102 between the lower protrusion LP and the channel structure CH may be on a third level LV3 higher than the second level LV2. In an implementation, the second level LV2 may be above the first level LV1 in a vertical direction, and the third level LV3 may be above the second level LV2 in a vertical direction. In an implementation, the second level LV2 may be above the first level LV1 in a vertical direction, and the third level LV3 may be above the second level LV2 in a vertical direction relative to a bottom of the substrate 201.

The first level LV1 may be equal to or lower than the fourth level LV4, which is a level of a lower end of the channel structure CH. The upper surface of the first horizontal conductive layer 102 may also be on a plurality of levels. In an implementation, a level of the upper end of the first horizontal conductive layer 102 in a region in contact with the channel layer 140 may be higher than a level of the upper surface of the first horizontal conductive layer 102 in the region in contact with the separation region MS, and a level of the upper surface of the first horizontal conductive layer 102 between the channel structure CH and the opening SO may be lower than the levels mentioned above.

In an implementation, the level of the upper end of the first horizontal conductive layer 102 in a region in contact with the channel layer 140 may be above in a vertical direction, the level of the upper surface of the first horizontal conductive layer 102 in the region in contact with the separation region MS, and a level of the upper surface of the first horizontal conductive layer 102 between the channel structure CH and the opening SO may be below in a vertical direction, the levels mentioned above.

The second horizontal conductive layer 104 may be on the first horizontal conductive layer 102. Differently from the first horizontal conductive layer 102, the second horizontal conductive layer 104 may not continuously extend and may have an opening SO. The opening SO may be in a region perpendicularly overlapping the separation regions MS. The thickness of the second horizontal conductive layer 104 may be smaller than that of the first horizontal conductive layer 102.

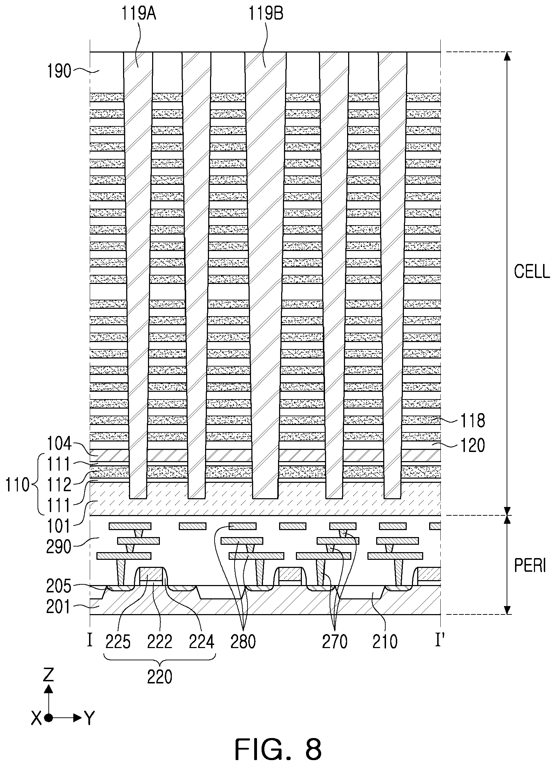

The first and second horizontal conductive layers 102 and 104 may be semiconductor layers including a semiconductor material, and may include, e.g., polycrystalline silicon. In this case, e.g., the first horizontal conductive layer 102 may be a layer doped with impurities of the same conductivity type as that of the plate layer 101. The second horizontal conductive layer 104 may be a doped layer or an intrinsic semiconductor layer including impurities diffused from the first horizontal conductive layer 102. The material of the second horizontal conductive layer 104 may be replaced with an insulating layer in example embodiments. In example embodiments, an insulating layer having a relatively thin thickness may be interposed between the upper surface of the first horizontal conductive layer 102 and the lower surface of the second horizontal conductive layer 104. The insulating layer may be a portion of the horizontal insulating layer 110 (see FIG. 8) remaining without being removed during the process of manufacturing the semiconductor device 100.

The gate electrodes 130 may be vertically stacked and spaced apart from each other on the source structure SS and may form a stack structure GS. The gate electrodes 130 may include lower gate electrodes 130L forming a gate of a ground select transistor, memory gate electrodes 130M forming a plurality of memory cells, and upper gate electrodes 130U forming gates of string select transistors. The number of memory gate electrodes 130M included in memory cells may be determined depending on capacity of the semiconductor device 100. In example embodiments, the number of upper and lower gate electrodes 130U and 130L may be one to four or more, and may have a structure the same as or different from that of the memory gate electrodes 130M. In example embodiments, the gate electrodes 130 may further include a gate electrode 130 below the upper gate electrodes 130U and/or lower gate electrodes 130L of the upper gate electrodes 130U and included in an erase transistor used for an erase operation using a gate induced drain leakage (GIDL) phenomenon. Also, a portion of the gate electrodes 130, e.g., memory gate electrodes 130M adjacent to the upper or lower gate electrodes 130U and 130L may be dummy gate electrodes.

The gate electrodes 130 may include a metal material, such as tungsten (W). In example embodiments, the gate electrodes 130 may include polycrystalline silicon or a metal silicide material. In example embodiments, the gate electrodes 130 may further include a diffusion barrier. In an implementation, the diffusion barrier may include tungsten nitride (WN), tantalum nitride (TaN), or titanium nitride (TiN), or a combination thereof.

The interlayer insulating layers 120 may be on the source structure SS and may be between the gate electrodes 130. Similarly to the gate electrodes 130, the interlayer insulating layers 120 may also be spaced apart from each other in a direction perpendicular to the upper surface of the source structure SS. The interlayer insulating layers 120 may include an insulating material such as silicon oxide or silicon nitride.

Each of the channel structures CH may form a memory cell string and may be spaced apart from each other while forming rows and columns on the source structure SS. The channel structures CH may be disposed to form a lattice pattern in an x-y plane or may be arranged in a zigzag pattern in one direction. The channel structures CH may have a cylindrical shape filling the channel hole, and may have an inclined side surface of which a width may decrease toward the plate layer 101 depending on an aspect ratio. As illustrated in FIG. 3, each of the channel structures CH may include a channel layer 140, a channel dielectric layer 145 on an external side surface of the channel layer 140, a channel filling insulating layer 147 in the channel layer 140, and a channel pad 149 on an upper end.

The channel layer 140 may be formed in an annular shape surrounding the channel filling insulating layer 147 therein. However, in example embodiments, the channel filling insulating layer 147 may not be provided, and the channel layer 140 may have a columnar shape such as a cylinder filling the channel hole. The channel layer 140 may be connected to the first horizontal conductive layer 102 in a lower portion. The channel layer 140 may include a semiconductor material such as polycrystalline silicon or single crystal silicon.

The channel dielectric layer 145 may be between the gate electrodes 130 and the channel layer 140. The channel dielectric layer 145 may be disposed to cover an internal side surface and a bottom surface of the channel hole in which the channel structure CH is disposed. The channel dielectric layer 145 may include a tunneling layer, a charge storage layer, and a blocking layer stacked in order from the gate electrodes 130. The tunneling layer may tunnel electric charges into the charge storage layer, and may include, e.g., silicon oxide (SiO₂), silicon nitride (Si₃N₄), silicon oxynitride (SiON), or a combination thereof. The charge storage layer may be a charge trap layer or a floating gate conductive layer. The blocking layer may include silicon oxide (SiO₂), silicon nitride (Si₃N₄), silicon oxynitride (SiON), a high-k dielectric material, or a combination thereof. In example embodiments, at least a portion of the channel dielectric layer 145 may extend in a horizontal direction along the gate electrodes 130.

The channel filling insulating layer 147 may be disposed to fill a channel hole inside the channel layer 140. The channel filling insulating layer 147 may include an insulating material, e.g., silicon oxide (SiO₂), silicon nitride (Si₃N₄), silicon oxynitride (SiON), or a combination thereof.

The channel pad 149 may be on an upper end of the channel layer 140 in the channel structure CH. The channel pad 149 may be physically and electrically connected to the channel layer 140. The channel pad 149 may include, e.g., doped polycrystalline silicon or doped monocrystalline silicon.

The upper separation regions US may extend in the x-direction between separation regions MS adjacent to each other in the y-direction. The upper separation regions US may be disposed to penetrate through a portion of the gate electrodes 130 including the uppermost upper gate electrode among the gate electrodes 130. The upper separation regions US may isolate, e.g., three gate electrodes 130 from each other in the y-direction. However, the number of gate electrodes 130 isolated by the upper separation regions US may be varied in example embodiments. The upper separation regions US may include an insulating material.

The separation regions MS may extend in the x-direction and may isolate the gate electrodes 130 from each other in the y-direction. As illustrated in FIG. 1, the separation regions MS may be parallel to each other, and may have curved shapes on side surfaces in the y-direction in a plan view. The separation regions MS may have, e.g., a shape in which circular shapes are expanded and connected to each other. Accordingly, the separation region MS may not have a constant width in the y-direction and may have a plurality of widths.

As illustrated in FIG. 2, the separation regions MS may penetrate through the gate electrodes 130, the interlayer insulating layers 120, and the second horizontal conductive layer 104, may extend in the z-direction, and may be in contact with the first horizontal conductive layer 102. The separation regions MS may have a shape of which a width may decrease toward the source structure SS due to a high aspect ratio. The upper surfaces of the separation regions MS may be on substantially the same level as a level of the upper surfaces of the channel structures CH.

Each of the separation regions MS may extend while covering the upper and side surfaces of the second horizontal conductive layer 104 in a lower portion thereof. The separation region MS may fill the opening SO of the second horizontal conductive layer 104, and a lower surface or a lower end of the separation region MS may be in contact with the first horizontal conductive layer 102. The separation region MS may have side surfaces of a constant slope on the second horizontal conductive layer 104, may be bent along the side surfaces of the second horizontal conductive layer 104 and may have a discontinuously reduced width. The separation region MS may be bent along the upper surface and side surfaces of the second horizontal conductive layer 104 on ends of the second horizontal conductive layer 104. The separation region MS may have a first width W1 in the y-direction within the opening SO and may have a second width W2 greater than the first width W1 on the opening SO and the second horizontal conductive layer 104. The first width W1 may range from about 60 nm to about 100 nm. In the first horizontal conductive layer 102, a distance between the channel structure CH and the separation region MS may be greater than the first width W1.

Each of the separation regions MS may include a separation insulating layer 105 in a trench. The separation insulating layer 105 may include an insulating material, e.g., silicon oxide, silicon nitride, or silicon oxynitride. In example embodiments, a conductive layer may be further within the separation insulating layer 105. In this case, the conductive layer may function as a contact plug electrically connected to the source structure SS.

The contact plugs 170 may be on the channel structures CH. The contact plugs 170 may have a cylindrical shape and may have inclined side surfaces such that a width thereof may decrease toward the plate layer 101 depending on an aspect ratio. The contact plugs 170 may electrically connect the channel structures CH to upper interconnection structures such as bit lines. The contact plugs 170 may be formed of a conductive material, and may include, e.g., tungsten (W), aluminum (Al), or copper (Cu).

The cell region insulating layer 190 may be disposed to cover the gate electrodes 130 and the channel structures CH. The cell region insulating layer 190 may include a plurality of insulating layers in example embodiments. The cell region insulating layer 190 may be formed of an insulating material, and may include, e.g., silicon oxide, silicon nitride, or silicon oxynitride.

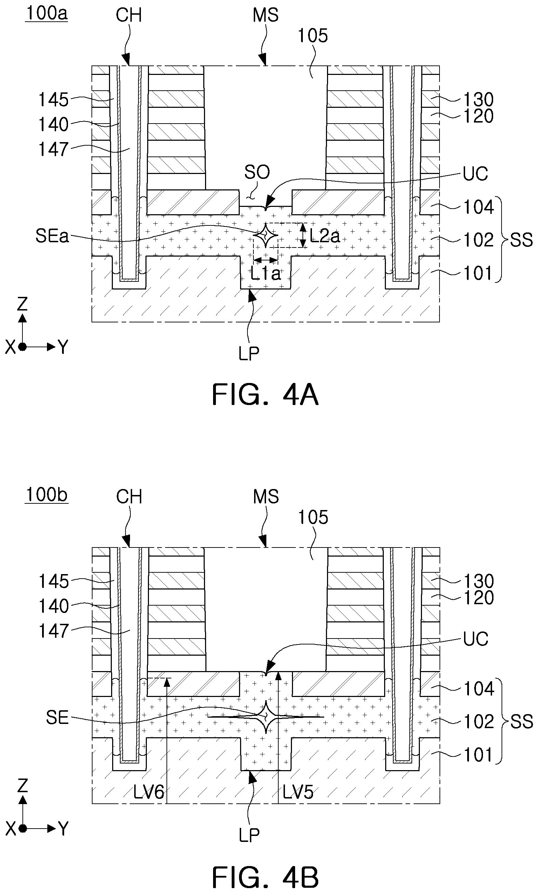

FIGS. 4A to 4C are enlarged views illustrating a portion of a semiconductor device according to an example embodiment, illustrating regions corresponding to the region "A" in FIG. 2.

Referring to FIG. 4A, in a semiconductor device 100a, the shape of the seam SEa in the first horizontal conductive layer 102 may be different from the shape thereof in the example embodiment in FIG. 3. In the example embodiment, the shim SEa may have a first length L1a in the y-direction and a second length L2a similar to or greater than the first length L1a in the z-direction. As such, the shape of the seam SEa may be varied in the example embodiments depending on the thickness of the first horizontal conductive layer 102, the depth of the lower protrusion LP, or the like.

Referring to FIG. 4B, in the semiconductor device 100b, the level of the upper surface of the first horizontal conductive layer 102 in contact with the separation region MS may be different from the level thereof in the example embodiment in FIG. 3. The fifth level LV5 of the uppermost surface of the first horizontal conductive layer 102 in contact with the separation region MS may be the same as or similar to the level of the upper surface of the second horizontal conductive layer 104. The fifth level LV5 may be higher than the sixth level LV6, which is a level of an upper end of the first horizontal conductive layer 102 in a region in contact with the channel layers 140. In the example embodiment, the first horizontal conductive layer 102 may entirely cover side surfaces of the second horizontal conductive layer 104 exposed through the opening SO. In an implementation, the fifth level LV5 may be above the sixth level LV6 in a vertical direction.

In example embodiments, the level of the uppermost surface in contact with the separation region MS in the first horizontal conductive layer 102 may be varied in a range of not extending to the upper surface of the second horizontal conductive layer 104 as described above.

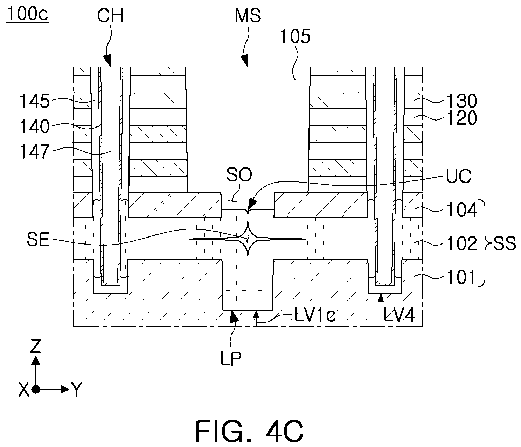

Referring to FIG. 4C, in the semiconductor device 100c, the level of the lower end of the lower protrusion LP of the first horizontal conductive layer 102 may be different from the level thereof in the example embodiment in FIG. 3. The first level LV1c of the lower end of the lower protrusion LP may be lower than the level LV4 of the lower end of the channel structures CH. In an implementation, on the same level, when the width of the lower protrusion LP in the y-direction is greater than the width of the channel structures CH, the lower protrusion LP may be relatively deeply recessed into the plate layer 101. In an implementation, the first level LV1c may be below the level LV4 of the lower end of the channel structures CH in a vertical direction.

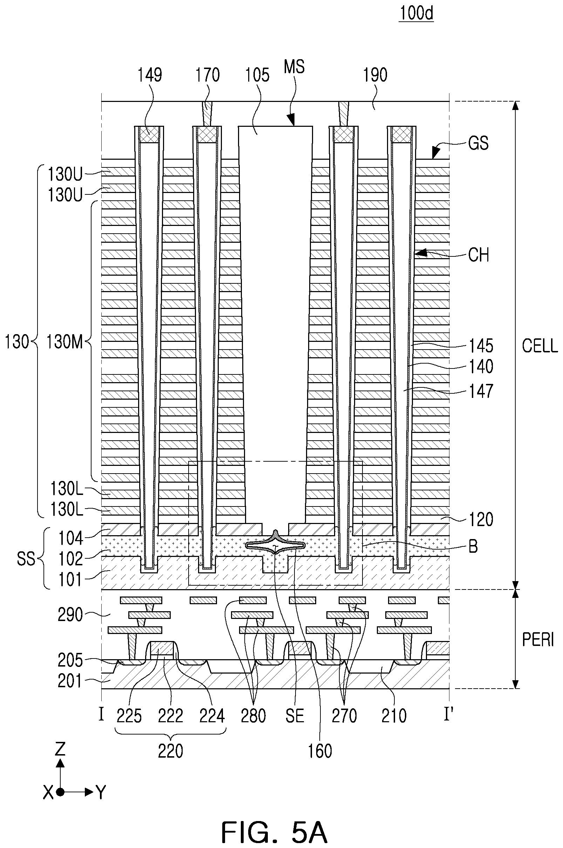

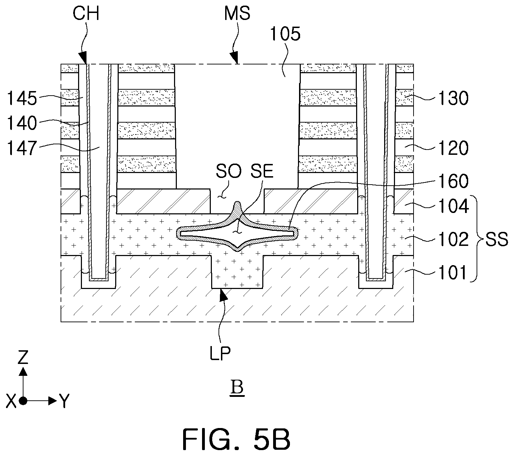

FIGS. 5A and 5B are a cross-sectional view illustrating a semiconductor device and an enlarged view illustrating a portion of a semiconductor device according to an example embodiment, illustrating region "B" in FIG. 5A.

Referring to FIGS. 5A and 5B, the memory cell region CELL of a semiconductor device 100d may further include a source insulating layer 160 within the seam SE of the first horizontal conductive layer 102. The source insulating layer 160 may extend along the circumference of the core SE and may be exposed through the upper surface of the first horizontal conductive layer 102. In an implementation, as illustrated in FIG. 5B, the source insulating layer 160 may protrude into the opening SO of the second horizontal conductive layer 104 through the upper surface of the first horizontal conductive layer 102. The protruding height of the source insulating layer 160 may be varied in example embodiments. In some example embodiments, the source insulating layer 160 may not protrude to the upper surface of the first horizontal conductive layer 102. In example embodiments, the degree to which the source insulating layer 160 fills the seam SE may be varied.

The source insulating layer 160 may be formed of an insulating material, and may include, e.g., silicon oxide, silicon nitride, or silicon oxynitride.

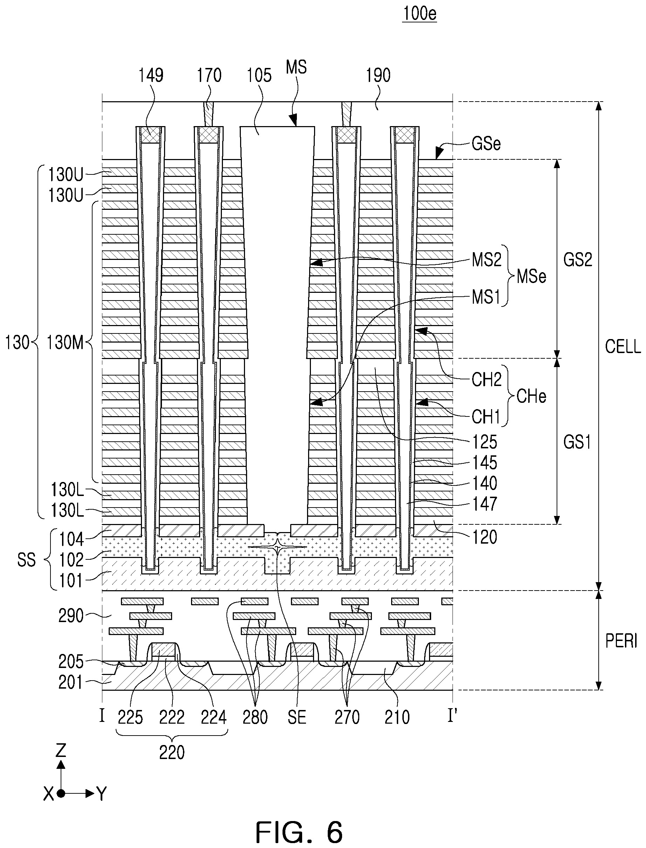

FIG. 6 is a cross-sectional view illustrating a semiconductor device according to an example embodiment.

Referring to FIG. 6, in the semiconductor device 100e, the stack structure GSe of the gate electrodes 130 may include first and second stack structures GS1 and GS2 vertically stacked. The channel structures CHe may include first and second channel structures CH1 and CH2 vertically stacked. Also, the separation region MSe may include first and second separation regions MS1 and MS2 vertically stacked. An upper end of the first stack structure GS1, an upper end of the first channel structure CH 1, and an upper end of the first separation region MS1 may be on substantially the same level. An upper interlayer insulating layer 125 having a relatively thick thickness may be on the upper end of the first stack structure GS1. However, the shapes of the interlayer insulating layers 120 and the upper interlayer insulating layer 125 may be varied in example embodiments.

Each of the channel structures CHe may have a form in which the lower first channel structures CH1 and the upper second channel structures CH2 are connected to each other, and may have a bent portion due to a difference in width in the connection region. The channel layer 140, the channel dielectric layer 145, and the channel filling insulating layer 147 may be connected to each other between the first channel structure CH1 and the second channel structure CH2. The channel pad 149 may be only on an upper end of the upper second channel structure CH2. However, in example embodiments, each of the first channel structure CH1 and the second channel structure CH2 may include a channel pad 149. In this case, the channel pad 149 of the first channel structure CH1 may be connected to the channel layer 140 of the second channel structure CH2.

The separation region MSe may have a shape in which the lower first separation region MS1 and the upper second separation region MS2 are connected to each other, and may have a bent portion due to a difference in width in the connection region.

Such a multi-stack structure may be used to stably form the channel structures CHe when the number of the stacked gate electrodes 130 is relatively large. In example embodiments, the number of stacked stack structures, channel structures, and separation regions may be varied, and the structure of the example embodiment may be applied to other example embodiments.

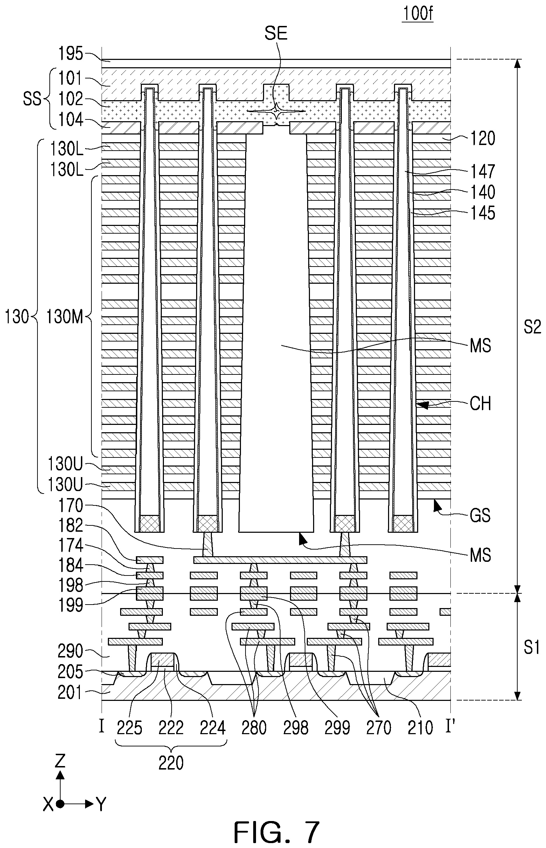

FIG. 7 is a cross-sectional view illustrating a semiconductor device according to an example embodiment.

Referring to FIG. 7, a semiconductor device 100f may include a first semiconductor structure S1 and a second semiconductor structure S2 bonded by a wafer bonding method.

The description of the peripheral circuit region PERI described above with reference to FIG. 2 may be applied to the first semiconductor structure S1. However, the first semiconductor structure S1 may further include first bonding vias 298 and first bonding pads 299 which may be bonding structures. The first bonding vias 298 may be above the uppermost lower interconnection lines 280 and may be connected to the lower interconnection lines 280. At least a portion of the first bonding pads 299 may be connected to the first bonding vias 298 on the first bonding vias 298. The first bonding pads 299 may be connected to the second bonding pads 199 of the second semiconductor structure S2. The first bonding pads 299 may provide an electrical connection path according to bonding of the first semiconductor structure S1 and the second semiconductor structure S2 together with the second bonding pads 199. The first bonding vias 298 and the first bonding pads 299 may include a conductive material, such as copper (Cu).

As for the second semiconductor structure S2, the description with reference to FIGS. 1 to 3 may be applied unless otherwise indicated. The second semiconductor structure S2 may further include lower contact plugs 182 and lower interconnection lines 184, which may be interconnection structures, and may further include second bonding vias 198 and second bonding pads 199, which may be bonding structures. The second semiconductor structure S2 may further include a protective layer 195 covering an upper surface of the plate layer 101.

The lower contact plugs 182 may be below the interconnection lines 180 and may connect the interconnection lines 180 to the lower interconnection lines 184. However, in example embodiments, the number of layers of the contact plugs and interconnection lines included in the interconnection structure and the arrangement thereof may be varied. The lower contact plugs 182 and the lower interconnection lines 184 may be formed of a conductive material, and may include, e.g., tungsten (W), aluminum (Al), or copper (Cu).

The second bonding vias 198 and the second bonding pads 199 may be below the lowermost lower interconnection lines 184. The second bonding vias 198 may be connected to the interconnection lines 180 and the second bonding pads 199, and the second bonding pads 199 may be bonded to the first bonding pads of the first semiconductor structure S1. The second bonding vias 198 and the second bonding pads 199 may include a conductive material, such as copper (Cu).

The first semiconductor structure S1 and the second semiconductor structure S2 may be bonded to copper (Cu)-to-copper (Cu) by the first bonding pads 299 and the second bonding pads 199. In addition to the copper (Cu)-to-copper (Cu) bonding, the first semiconductor structure S1 and the second semiconductor structure S2 may be further bonded by dielectric-to-dielectric bonding. The dielectric-dielectric bonding may form a portion of each of the peripheral region insulating layer 290 and the cell region insulating layer 190 and may be bonding by dielectric layers surrounding each of the first bonding pads 299 and the second bonding pads 199. Accordingly, the first semiconductor structure S1 and the second semiconductor structure S2 may be bonded to each other without an adhesive layer.

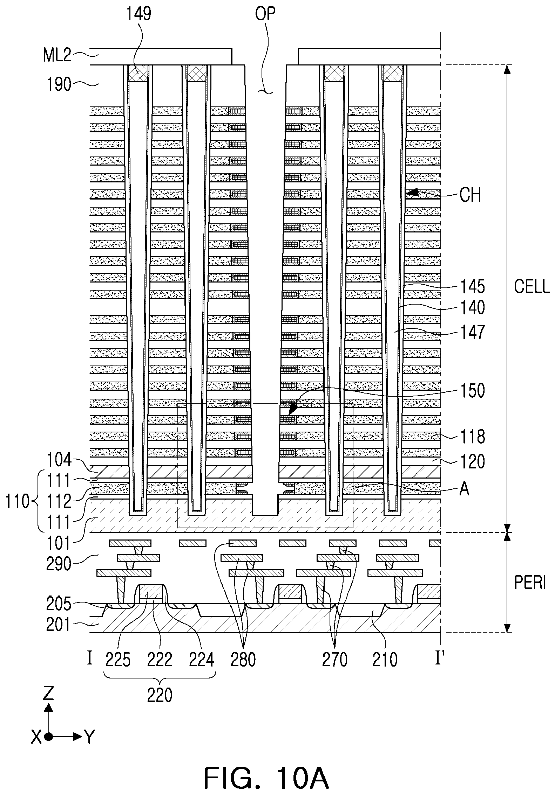

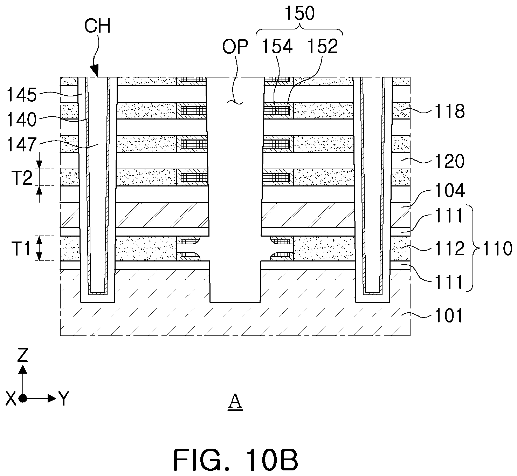

FIGS. 8 to 14 are cross-sectional views illustrating a method of manufacturing a semiconductor device according to an example embodiment. FIGS. 8, 9, 10A, 11A, 12A, 13A, and 14 illustrate regions corresponding to the region illustrated in FIG. 2. FIGS. 10B, 11B, 12B, and 13B illustrate region "A" in FIGS. 10A, 11A, 12A, and 13A, respectively, in an enlarged manner.

Referring to FIG. 8, a peripheral circuit region PERI may be formed, a plate layer 101, a horizontal insulating layer 110, and a second horizontal conductive layer 104 may be on the peripheral circuit region PERI, sacrificial insulating layers 118 and interlayer insulating layers 120 may be alternately stacked, a cell region insulating layer 190 may be formed, and first and second vertical sacrificial layers 119A and 119B may be formed.

First, device isolation layers 210 may be formed in the substrate 201, and a circuit gate dielectric layer 222 and a circuit gate electrode 225 may be formed in order on the substrate 201. The device isolation layers 210 may be formed by, e.g., a shallow trench separation (STI) process. The circuit gate dielectric layer 222 and the circuit gate electrode 225 may be formed using atomic layer deposition (ALD) or chemical vapor deposition (CVD). The circuit gate dielectric layer 222 may be formed of silicon oxide, and the circuit gate electrode 225 may be formed of polycrystalline silicon or a metal silicide layer. Thereafter, a spacer layer 224 and impurity regions 205 may be on both sidewalls of the circuit gate dielectric layer 222 and the circuit gate electrode 225. In example embodiments, the spacer layer 224 may include a plurality of layers. Thereafter, the impurity regions 205 may be formed by performing an ion implantation process.

Among the circuit interconnection structures, the lower contact plugs 270 may be formed by forming a portion of the peripheral region insulating layer 290, removing the portion by etching, and filling the conductive material therein. The lower interconnection lines 280 may be formed by, e.g., depositing and patterning a conductive material.

The peripheral region insulating layer 290 may include a plurality of insulating layers. The peripheral region insulating layer 290 may be partially formed in each process of forming the circuit interconnection structures and may be partially on the uppermost lower interconnection line 280, such that the peripheral region insulating layer 290 may cover the circuit devices 220 and the circuit interconnection structures. Accordingly, the peripheral circuit region PERI may be formed.

Thereafter, the plate layer 101 may be formed on the peripheral region insulating layer 290. The plate layer 101 may be formed of, e.g., polycrystalline silicon and may be formed by a CVD process. Polycrystalline silicon included in the plate layer 101 may include impurities.

The first and second horizontal insulating layers 111 and 112 included in the horizontal insulating layer 110 may be alternately stacked on the plate layer 101. A portion of the horizontal insulating layer 110 may be replaced with the first horizontal conductive layer 102 in FIG. 2 through a subsequent process. The first horizontal insulating layers 111 may include a material different from that of the second horizontal insulating layer 112. In an implementation, the first horizontal insulating layers 111 may be formed of the same material as that of the interlayer insulating layers 120, and the second horizontal insulating layer 112 may be formed of the same material as that of the subsequent sacrificial insulating layers 118. A portion of the horizontal insulating layer 110 may be removed by a patterning process in a partial region, e.g., a region in which the channel structures CH (see FIG. 2) are not formed. The second horizontal conductive layer 104 may be on the horizontal insulating layer 110.

Thereafter, the sacrificial insulating layers 118 and the interlayer insulating layers 120 may be alternately stacked and may form the cell region insulating layer 190. The sacrificial insulating layers 118 may be replaced with the gate electrodes 130 (see FIG. 2) through a subsequent process. The sacrificial insulating layers 118 may be formed of a material different from that of the interlayer insulating layers 120, and may be formed of a material etched with etch selectivity with respect to the interlayer insulating layers 120 under specific etching conditions. In an implementation, the interlayer insulating layer 120 may be formed of silicon oxide or silicon nitride, and the sacrificial insulating layers 118 may be formed of a material different from a material of an interlayer insulating layer 120, e.g., silicon, silicon oxide, silicon carbide, or silicon nitride. However, in example embodiments, the interlayer insulating layers 120 may not have the same thickness. The thicknesses of the interlayer insulating layers 120 and the sacrificial insulating layers 118 and the number of layers included therein may be varied from the illustrated examples.

Thereafter, first and second vertical sacrificial layers 119A and 119B may be formed. Each of the first and second vertical sacrificial layers 119A and 119B may have a cylindrical shape. The first vertical sacrificial layers 119A may be formed in a region corresponding to the channel structures CH in FIG. 2, and the second vertical sacrificial layers 119B may be formed in a region corresponding to a portion of the separation region MS and a portion of the first horizontal conductive layer 102 in FIG. 2. The second vertical sacrificial layer 119B may be formed in a size corresponding to the opening SO of the second horizontal conductive layer 104 and the lower protrusion LP of the first horizontal conductive layer 102 in FIGS. 2 and 3. The second vertical sacrificial layer 119B may be spaced apart from the adjacent second vertical sacrificial layer 119B in the x-direction.

The first and second vertical sacrificial layers 119A and 119B may be formed by forming through holes penetrating through the mold structure of the sacrificial insulating layers 118, the second horizontal conductive layer 104, and the horizontal insulating layer 110, depositing a material forming the first and second vertical sacrificial layers 119A and 119B in the through holes, and performing a planarization process. The first and second vertical sacrificial layers 119A and 119B may include a material different from those of the interlayer insulating layers 120 and the sacrificial insulating layers 118. In an implementation, the first and second vertical sacrificial layers 119A and 119B may include a semiconductor material such as polycrystalline silicon, a silicon-based insulating material, or a carbon-based material.

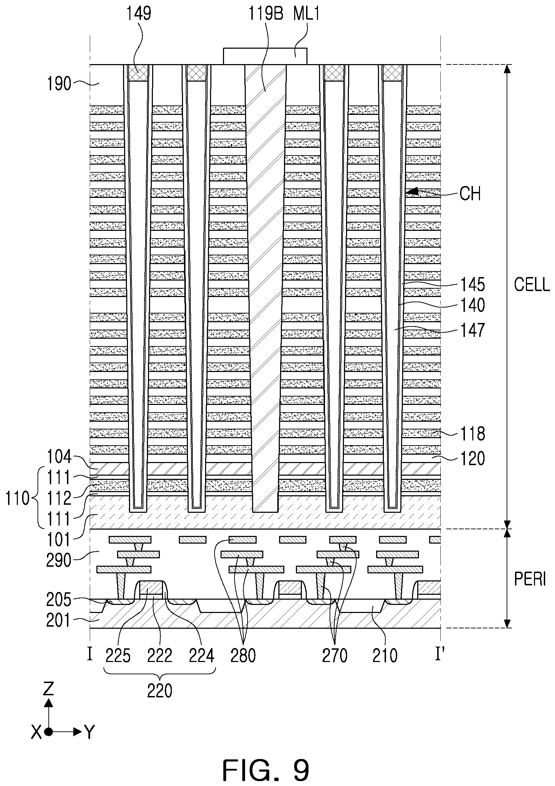

Referring to FIG. 9, channel structures CH may be formed by removing the first vertical sacrificial layers 119A. First, the upper separation regions US in FIG. 1 may be formed by removing portions of the sacrificial insulating layers 118 and the interlayer insulating layers 120. The region in which the upper separation regions US may be formed using a separate mask layer, a predetermined number of sacrificial insulating layers 118 and interlayer insulating layers 120 may be removed from the uppermost portion, and the insulating material may be deposited, thereby forming the upper separation regions US.

Thereafter, a first mask layer ML1 covering the second vertical sacrificial layer 119B may be formed, and the first vertical sacrificial layers 119A may be removed. A channel structure CH may be formed by forming a channel dielectric layer 145, a channel layer 140, a channel filling insulating layer 147, and a channel pad 149 in the through-holes from which the first vertical sacrificial layers 119A are removed. The channel layer 140 may be on the channel dielectric layer 145 within the channel structure CH. The channel filling insulating layer 147 may be formed to fill the through hole and may be formed of an insulating material. However, in example embodiments, the space between the channel layers 140 may be filled with a conductive material instead of the channel filling insulating layer 147. The channel pad 149 may be formed of a conductive material, e.g., polycrystalline silicon.

Referring to FIGS. 10A and 10B, the second vertical sacrificial layer 119B may be removed, and buried spacer layers 150 may be formed.

The separation opening OP may be formed by forming a second mask layer ML2 covering the channel structures CH and removing the second vertical sacrificial layer 119B.

Thereafter, the second horizontal insulating layer 112 and the sacrificial insulating layers 118 exposed through the separation opening OP may be partially removed from the side surfaces, and the buried spacer layers 150 may be on the side surfaces of the second horizontal insulating layer 112 and side surfaces of the sacrificial insulating layers 118.

The buried spacer layers 150 may include first and second buried spacer layers 152 and 154 stacked in order on side surfaces of the second horizontal insulating layer 112 and side surfaces of the sacrificial insulating layers 118. The first buried spacer layers 152 and the second buried spacer layers 154 may include different materials. In some example embodiments, the buried spacer layers 150 may further include a sealing nitride layer between side surfaces of the sacrificial insulating layers 118 and the first buried spacer layers 152. In example embodiments, the number of layers included in each of the buried spacer layers 150 and the form thereof may be varied.

The first and second buried spacer layers 150 may partially expose the second horizontal insulating layer 112. On the contrary, the first and second buried spacer layers 150 may completely cover side surfaces of the sacrificial insulating layers 118. This structure may be due to the formation of the buried spacer layers 150 using the configuration in which the thickness T1 of the second horizontal insulating layer 112 is greater than the thickness T2 of the sacrificial insulating layers 118.

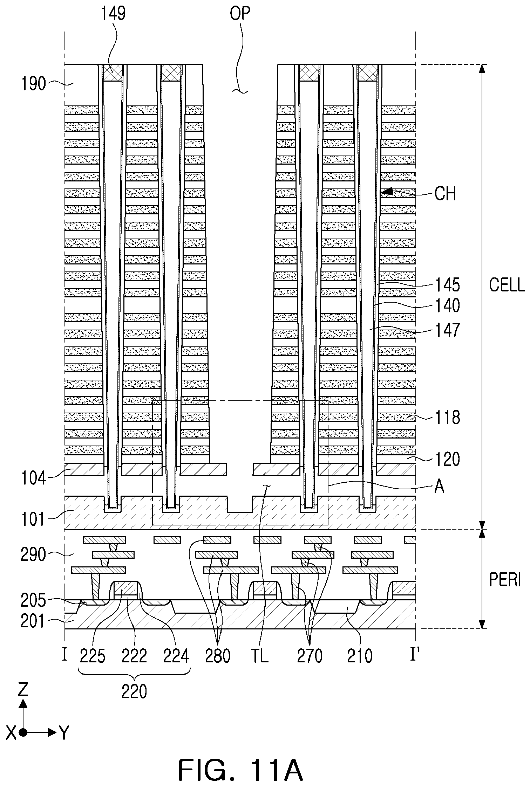

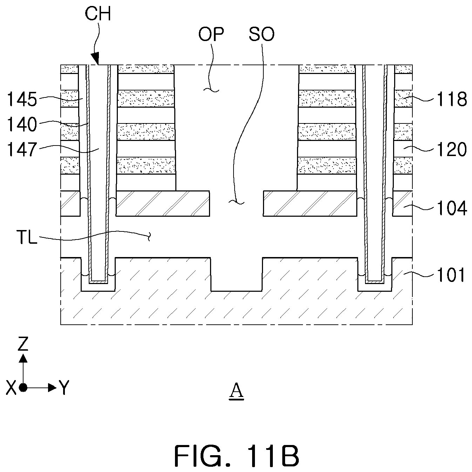

Referring to FIGS. 11A and 11B, a lateral tunnel portion TL may be formed by removing the horizontal insulating layer 110 exposed through the separation opening OP and the buried spacer layers 150.

The horizontal insulating layer 110 may be removed by, e.g., a wet etching process. First, the second horizontal insulating layer 112 exposed through the buried spacer layers 150 may be removed together with the second buried spacer layers 154, and after the second horizontal insulating layer 112 is removed, the exposed first horizontal insulating layers 111 may be removed together with the first buried spacer layers 152. During the process of removing the horizontal insulating layer 110, portions of the channel dielectric layers 145 may also be removed in the region from which the horizontal insulating layer 110 is removed, thereby exposing the channel layers 140. In a region between the channel structure CH and the separation opening OP, the height of the side tunnel portion TL may be greater than the width of the opening SO.

As the buried spacer layers 150 are removed together with the horizontal insulating layer 110, the separation opening OP may expand in the x-direction and y-direction, and the second horizontal conductive layer 104 may protrude into the separation opening OP. Through this process, the separation openings OP adjacent to each other in the x-direction may be connected to each other and may have a trench shape corresponding to the separation regions MS in FIG. 1.

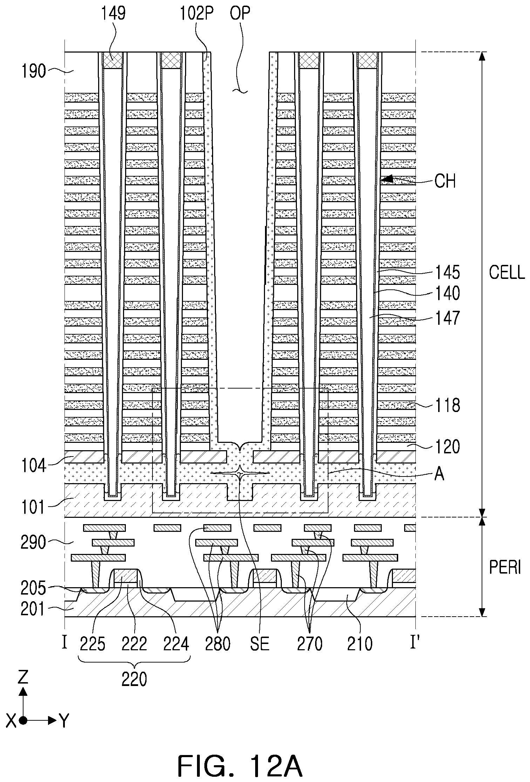

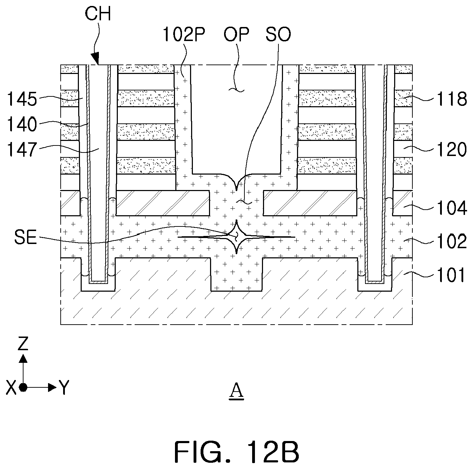

Referring to FIGS. 12A and 12B, a preliminary first horizontal conductive layer 102P may be formed in the separation opening OP and the side tunnel portion TL.

The preliminary first horizontal conductive layer 102P may be in contact with the channel layers 140 and may fill the side tunnel portion TL. The preliminary first horizontal conductive layer 102P may fill the opening SO of the second horizontal conductive layer 104 and may extend onto the second horizontal conductive layer 104. The preliminary first horizontal conductive layer 102P may cover an upper surface of the second horizontal conductive layer 104 and may extend to cover sidewalls of the separation opening OP on the second horizontal conductive layer 104.

The preliminary first horizontal conductive layer 102P may include a seam SE in a region overlapping the opening SO of the second horizontal conductive layer 104 in the z-direction in the side tunnel portion TL. Since the height of the lateral tunnel portion TL in the region between the channel structure CH and the separation opening OP is greater than the width of the opening SO, the seam SE may be formed in the tunnel portion TL below the opening SO.

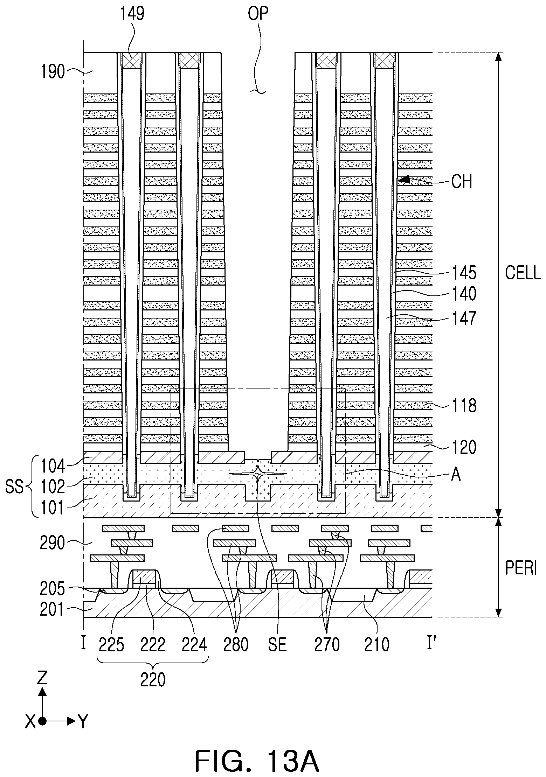

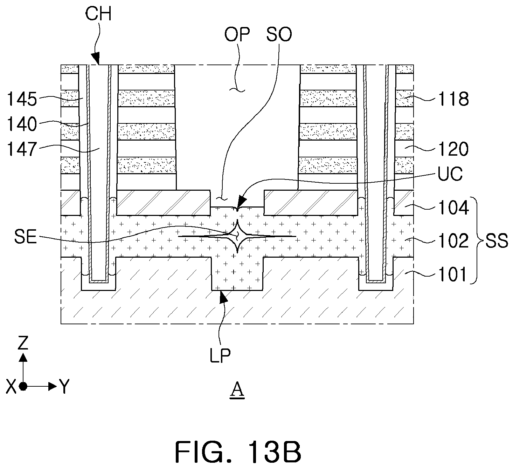

Referring to FIGS. 13A and 13B, the first horizontal conductive layer 102 may be formed by partially removing the preliminary first horizontal conductive layer 102P.

The preliminary first horizontal conductive layer 102P may be removed from the upper surface of the second horizontal conductive layer 104 and both sidewalls of the separation opening OP on the second horizontal conductive layer 104 by, e.g., a trim process. In this process, the level of the upper surface of the first horizontal conductive layer 102 exposed through the opening SO of the second horizontal conductive layer 104 may be controlled depending on the degree of removal of the preliminary first horizontal conductive layer 102P.

Through this process, a source structure SS including the plate layer 101 and the first and second horizontal conductive layers 102 and 104 may be formed.

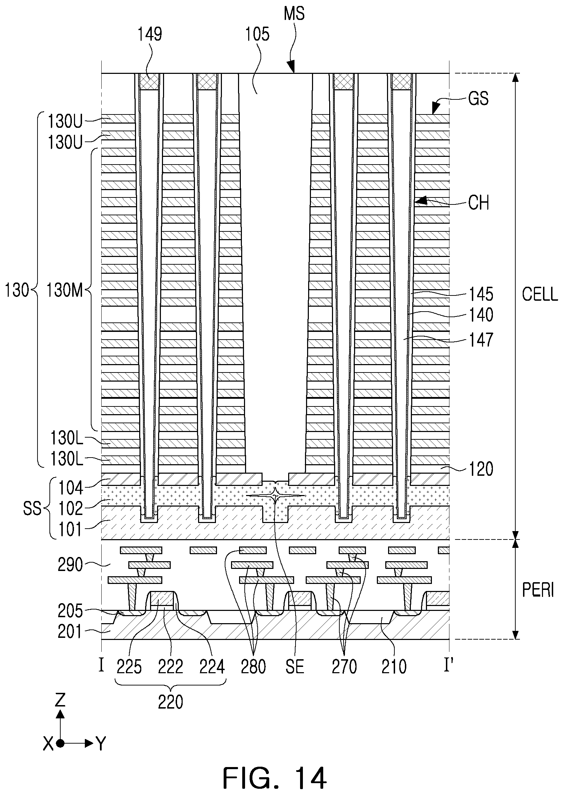

Referring to FIG. 14, the sacrificial insulating layers 118 may be removed, gate electrodes 130 may be formed and a separation region MS may be formed.

First, the sacrificial insulating layers 118 may be selectively removed with respect to the interlayer insulating layers 120 using, e.g., wet etching. The gate electrodes 130 may be formed by depositing a conductive material in regions from which the sacrificial insulating layers 118 are removed. The conductive material may include a metal, polycrystalline silicon or metal silicide material. In example embodiments, a portion of the channel dielectric layer 145 may be firstly formed before forming the gate electrodes 130.

After forming the gate electrodes 130, the conductive material deposited in the separation opening OP may be removed through an additional process, and an insulating material may be deposited, thereby forming the separation region MS including the separation insulating layer 105. The separation insulating layer 105 may be in contact with the first horizontal conductive layer 102.

Thereafter, referring to FIG. 2, a cell region insulating layer 190 may be further formed, and contact plugs 170 penetrating through the cell region insulating layer 190 and connected to the channel structures CH may be formed, thereby forming the semiconductor device 100.

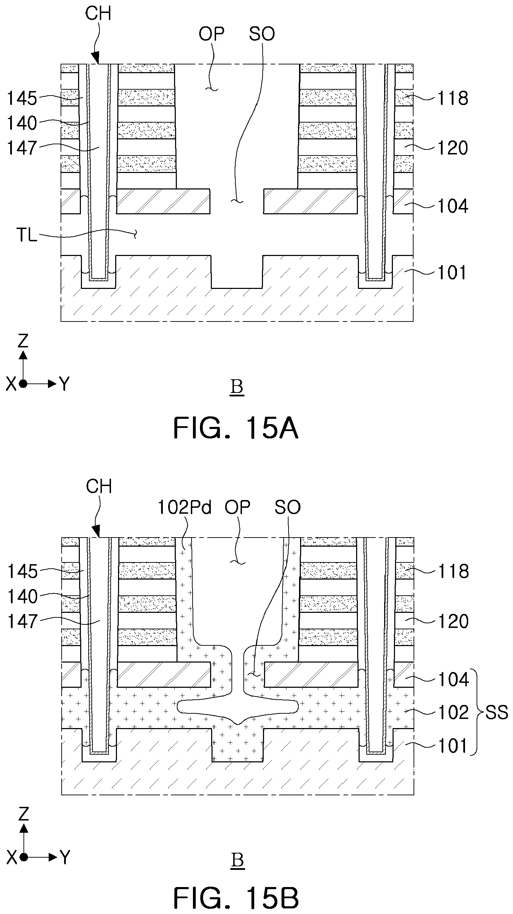

FIGS. 15A to 15E are cross-sectional views illustrating a method of manufacturing a semiconductor device according to an example embodiment, illustrating regions corresponding to regions illustrated in FIG. 5B.

Referring to FIG. 15A, the processes described above with reference to FIGS. 8 to 11B may be performed in the same manner. Accordingly, the horizontal insulating layer 110 may be removed and the side tunnel portion TL may be formed.

Referring to FIG. 15B, a preliminary first horizontal conductive layer 102Pd may be formed in the separation opening OP and the side tunnel portion TL.

The preliminary first horizontal conductive layer 102Pd may be formed in a manner similar to the example described above with reference to FIGS. 12A and 12B. However, in the example embodiment, the preliminary first horizontal conductive layer 102Pd may not completely fill the side tunnel portion TL and the opening SO of the second horizontal conductive layer 104.

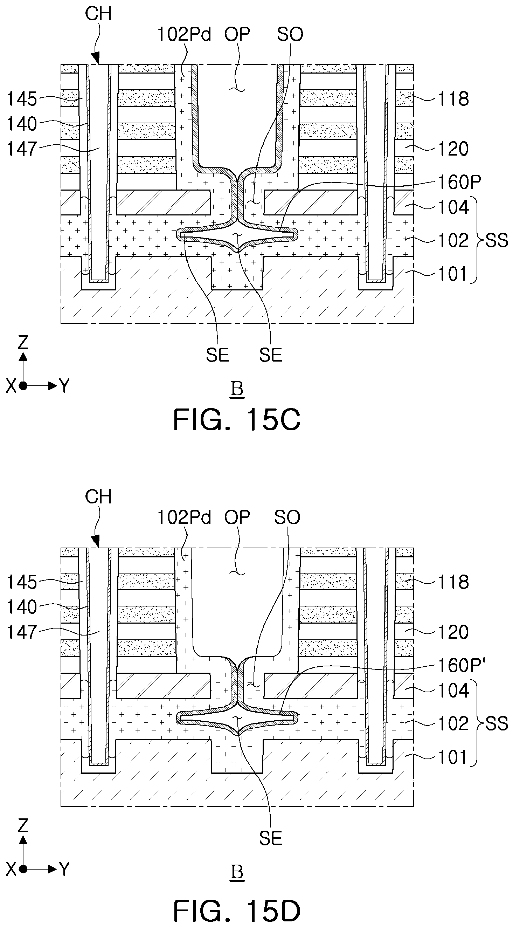

Referring to FIG. 15C, a preliminary source insulating layer 160P may be formed. The preliminary source insulating layer 160P may be conformally on the preliminary first horizontal conductive layer 102Pd. The preliminary source insulating layer 160P may fill the opening SO of the second horizontal conductive layer 104 and may be formed to surround the seam SE in the preliminary first horizontal conductive layer 102Pd. The preliminary source insulating layer 160P may be, e.g., oxide.

Referring to FIG. 15D, a portion of the preliminary source insulating layer 160P may be removed in the separation opening OP.

The preliminary source insulating layer 160P may be partially removed on the opening SO of the second horizontal conductive layer 104. The preliminary source insulating layer 160P may be removed from both side surfaces of the preliminary first horizontal conductive layer 102Pd in the separation opening OP.

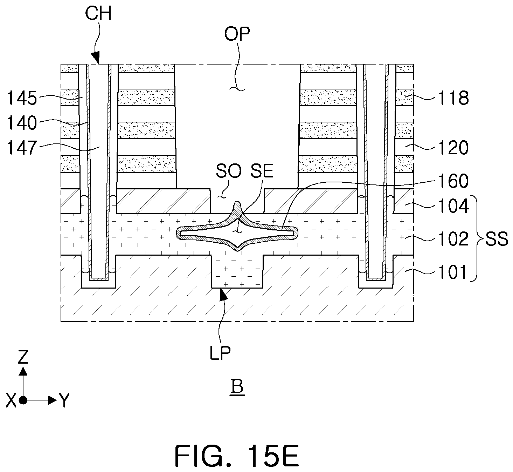

Referring to FIG. 15E, the first horizontal conductive layer 102 may be formed by partially removing the preliminary first horizontal conductive layer 102Pd.

The preliminary first horizontal conductive layer 102Pd may be removed from the upper surface of the second horizontal conductive layer 104 and sidewalls of the separation opening OP on the second horizontal conductive layer 104 in same manner as described above with reference to FIGS. 13A and 13B. Due to the preliminary source insulating layer 160P, the degree of removal of the preliminary first horizontal conductive layer 102Pd may be easily adjusted. Accordingly, a source structure SS including the plate layer 101 and the first and second horizontal conductive layers 102 and 104 may be formed.

During the process of partially removing the preliminary first horizontal conductive layer 102Pd described above, a portion of the upper end of the preliminary source insulating layer 160P may be removed such that the final form of the source insulating layer 160 may be formed.

Thereafter, referring to FIGS. 5A and 5B, by forming the separation region MS, the gate electrodes 130, and the contact plugs 170 as described above with reference to FIG. 14, the semiconductor device 100d may be manufactured.

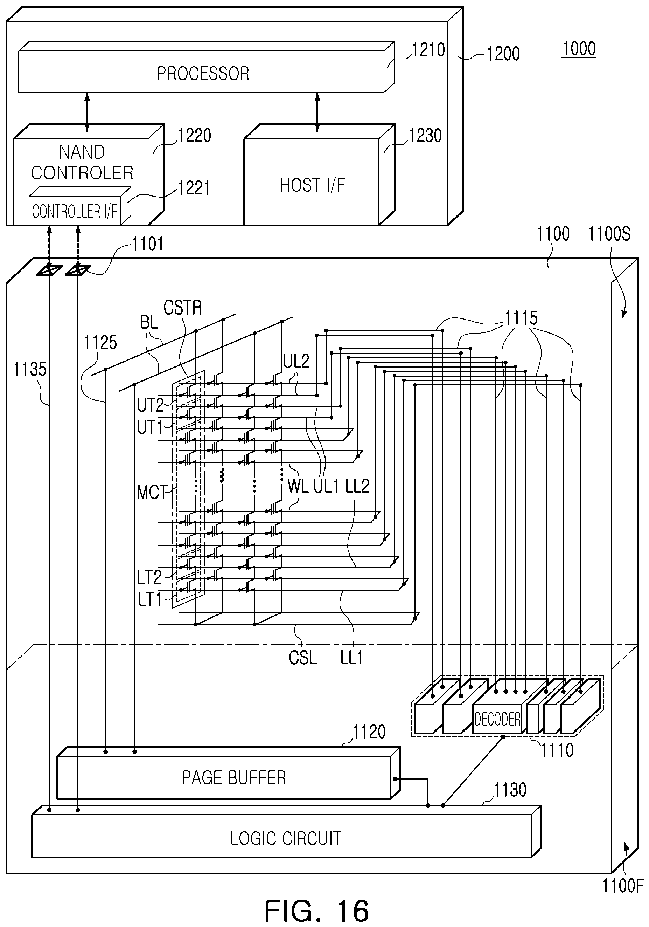

FIG. 16 is a view illustrating a data storage system including a semiconductor device according to an example embodiment.

Referring to FIG. 16, a data storage system 1000 may include a semiconductor device 1100 and a controller 1200 electrically connected to the semiconductor device 1100. The data storage system 1000 may be implemented as a storage device including one or a plurality of semiconductor devices 1100 or an electronic device including a storage device. In an implementation, the data storage system 1000 may be implemented as a solid state drive device (SSD) including one or a plurality of semiconductor devices 1100, a universal serial bus (USB), a computing system, a medical device, or a communication device.

The semiconductor device 1100 may be implemented as a non-volatile memory device, such as, e.g., the NAND flash memory device described in the aforementioned example embodiment with reference to FIGS. 1 to 7. The semiconductor device 1100 may include a first structure 1100F and a second structure 1100S on the first structure 1100F. In example embodiments, the first structure 1100F may be on the side of the second structure 1100S. The first structure 1100F may be implemented as a peripheral circuit structure including a decoder circuit 1110, a page buffer 1120, and a logic circuit 1130. The second structure 1100S may be implemented as a memory cell structure including a bit line BL, a common source line CSL, word lines WL, first and second gate upper lines UL1 and UL2, first and second gate lower lines LL1 and LL2 and memory cell strings CSTR between the bit line BL and the common source line CSL.

In the second structure 1100S, each of the memory cell strings CSTR may include lower transistors LT1 and LT2 adjacent to the common source line CSL, upper transistors UT1 and UT2 adjacent to the bit line BL, and a plurality of memory cell transistors MCT between the lower transistors LT1 and LT2 and the upper transistors UT1 and UT2. The number of lower transistors LT1 and LT2 and the number of upper transistors UT1 and UT2 may be varied in example embodiments.

In example embodiments, the upper transistors UT1 and UT2 may include a string select transistor, and the lower transistors LT1 and LT2 may include a ground select transistor. The gate lower lines LL1 and LL2 may be configured as gate electrodes of the lower transistors LT1 and LT2, respectively. The word lines WL may be configured as gate electrodes of the memory cell transistors MCT, and the gate upper lines UL1 and UL2 may be configured as gate electrodes of the upper transistors UT1 and UT2, respectively.

In example embodiments, the lower transistors LT1 and LT2 may include a lower erase control transistor LT1 and a ground select transistor LT2 connected to each other in series. The upper transistors UT1 and UT2 may include a string select transistor UT1 and an upper erase control transistor UT2 connected to each other in series. At least one of the lower erase control transistor LT1 and the upper erase control transistor UT2 may be used in an erase operation for erasing data stored in the memory cell transistors MCT using a GIDL phenomenon.

The common source line CSL, the first and second gate lower lines LL1 and LL2, the word lines WL, and the first and second gate upper lines UL1 and UL2 may be electrically connected to the decoder circuit 1110 through first connection interconnections 1115 extending from the first structure 1100F to the second structure 1100S. The bit lines BL may be electrically connected to the page buffer 1120 through second connection interconnections 1125 extending from the first structure 110F to the second structure 1100S.

In the first structure 1100F, the decoder circuit 1110 and the page buffer 1120 may perform a control operation on at least one selected memory cell transistor among the plurality of memory cell transistors MCT. The decoder circuit 1110 and the page buffer 1120 may be controlled by the logic circuit 1130. The semiconductor device 1100 may communicate with the controller 1200 through the input/output pad 1101 electrically connected to the logic circuit 1130. The input/output pad 1101 may be electrically connected to the logic circuit 1130 through an input/output connection line 1135 extending from the first structure 1100F to the second structure 1100S.

The controller 1200 may include a processor 1210, a NAND controller 1220, and a host interface 1230. In example embodiments, the data storage system 1000 may include a plurality of semiconductor devices 1100, and in this case, the controller 1200 may control the plurality of semiconductor devices 1100.

The processor 1210 may control overall operation of the data storage system 1000 including the controller 1200. The processor 1210 may operate according to a predetermined firmware, and may access the semiconductor device 1100 by controlling the NAND controller 1220. The NAND controller 1220 may include a controller interface 1221 processing communication with the semiconductor device 1100. Through the controller interface 1221, a control command for controlling the semiconductor device 1100, data to be written to the memory cell transistors MCT of the semiconductor device 1100, and data to be read from the memory cell transistors MCT of the semiconductor device 1100 may be transmitted. The host interface 1230 may provide a communication function between the data storage system 1000 and an external host. When a control command from an external host is received through the host interface 1230, the processor 1210 may control the semiconductor device 1100 in response to the control command.

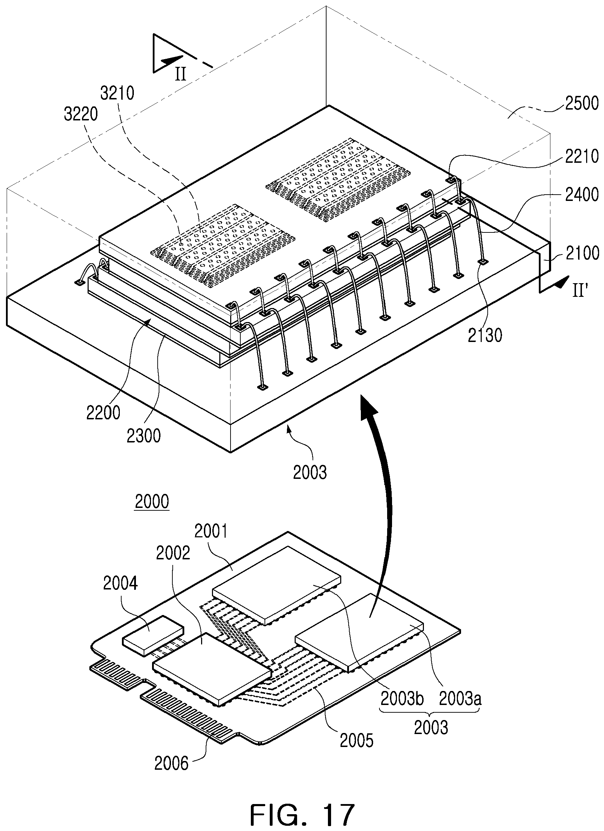

FIG. 17 is a perspective view illustrating a data storage system including a semiconductor device according to an example embodiment. Referring to FIG. 17, a data storage system 2000 in an example embodiment may include a main substrate 2001, a controller 2002 mounted on the main substrate 2001, one or more semiconductor packages 2003, and a DRAM 2004. The semiconductor package 2003 and the DRAM 2004 may be connected to the controller 2002 by interconnection patterns 2005 on the main substrate 2001.

The main substrate 2001 may include a connector 2006 including a plurality of pins coupled to an external host. The number and arrangement of the plurality of pins in the connector 2006 may vary depending on a communication interface between the data storage system 2000 and the external host. In example embodiments, the data storage system 2000 may communicate with an external host according to one of interfaces selected from universal serial bus (USB), peripheral component interconnect express (PCI-Express), serial advanced technology attachment (SATA), and M-Phy for universal flash storage (UFS). In example embodiments, the data storage system 2000 may operate by power supplied from an external host through the connector 2006. The data storage system 2000 may further include a power management integrated circuit (PMIC) for distributing power supplied from the external host to the controller 2002 and the semiconductor package 2003. The controller 2002 may write data to or may read data from the semiconductor package 2003 and may improve an operating speed of the data storage system 2000.

The DRAM 2004 may be configured as a buffer memory for alleviating a difference in speeds between the semiconductor package 2003, which is a data storage space, and an external host. The DRAM 2004 included in the data storage system 2000 may operate as a cache memory, and may provide a space for temporarily storing data in a control operation for the semiconductor package 2003. The data storage system 2000 may include the DRAM 2004, and the controller 2002 may further include a DRAM controller for controlling the DRAM 2004 in addition to the NAND controller for controlling the semiconductor package 2003.

The semiconductor package 2003 may include first and second semiconductor packages 2003a and 2003b spaced apart from each other. Each of the first and second semiconductor packages 2003a and 2003b may be configured as a semiconductor package including a plurality of semiconductor chips 2200. Each of the first and second semiconductor packages 2003a and 2003b may include a package substrate 2100, semiconductor chips 2200 on the package substrate 2100, adhesive layers 2300 on lower surfaces of the semiconductor chips 2200, respectively, a connection structure 2400 electrically connecting the semiconductor chips 2200 to the package substrate 2100, and a molding layer 2500 covering the semiconductor chips 2200 and the connection structure 2400 on the package substrate 2100.

The package substrate 2100 may be configured as a printed circuit board including package upper pads 2130. Each semiconductor chip 2200 may include an input/output pad 2210. The input/output pad 2210 may correspond to the input/output pad 1101 in FIG. 16. Each of the semiconductor chips 2200 may include gate stack structures 3210 and channel structures 3220. Each of the semiconductor chips 2200 may include the semiconductor device described in the aforementioned example embodiment with reference to FIGS. 1 to 7.

In example embodiments, the connection structure 2400 may be configured as a bonding wire electrically connecting the input/output pad 2210 to the package upper pads 2130. Accordingly, in each of the first and second semiconductor packages 2003a and 2003b, the semiconductor chips 2200 may be electrically connected to each other by a bonding wire method, and may be electrically connected to the package upper pads 2130 of the package substrate 2100. In example embodiments, in each of the first and second semiconductor packages 2003a and 2003b, the semiconductor chips 2200 may be electrically connected to each other by a connection structure including a through-electrode (TSV) instead of the connection structure 2400 of a bonding wire method.

In example embodiments, the controller 2002 and the semiconductor chips 2200 may be included in a single package. In an example embodiment, the controller 2002 and the semiconductor chips 2200 may be mounted on a separate interposer substrate different from the main substrate 2001, and the controller 2002 and the semiconductor chips 2200 may be connected to each other interconnection on the interposer substrate.

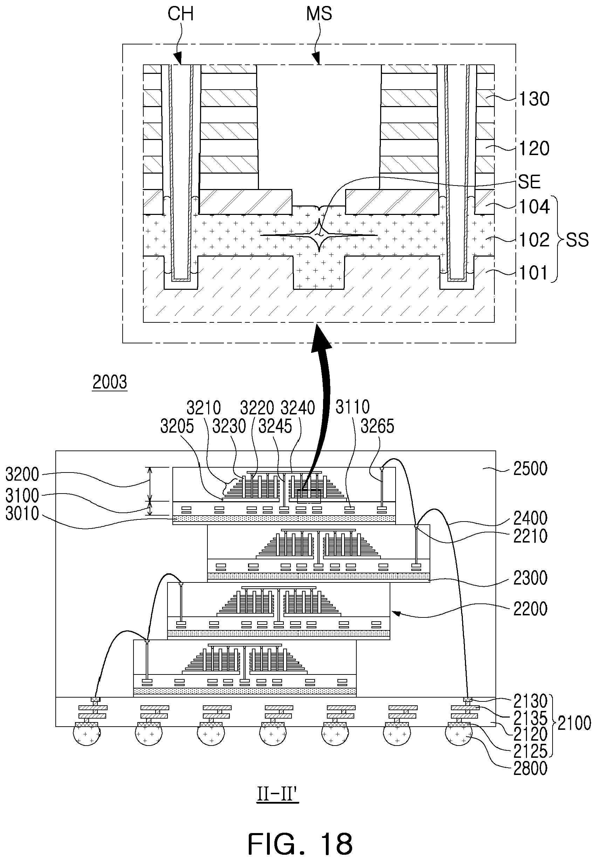

FIG. 18 is a cross-sectional view illustrating a semiconductor package according to an example embodiment, illustrating an example embodiment of the semiconductor package 2003 in FIG. 17 taken along line II-II' in FIG. 17. Referring to FIG. 18, in the semiconductor package 2003, the package substrate 2100 may be implemented as a printed circuit board. The package substrate 2100 may include a package substrate body 2120, package upper pads 2130 (see FIG. 17) on the upper surface of the package substrate body 2120, lower pads 2125 on the lower surface of the package substrate body 2120 or exposed through the lower surface, and internal interconnections 2135 electrically connecting the package upper pads 2130 to the lower pads 2125 in the package substrate body 2120. The lower pads 2125 may be connected to the interconnection patterns 2005 of the main substrate 2010 of the data storage system 2000 as illustrated in FIG. 17 through conductive connection portions 2800.

Each of the semiconductor chips 2200 may include a semiconductor substrate 3010, a first semiconductor structure 3100, and a second semiconductor structure 3200 stacked in sequence on the semiconductor substrate 3010. The first semiconductor structure 3100 may include a peripheral circuit region including peripheral interconnections 3110. The second semiconductor structure 3200 may include a common source line 3205, a gate stack structure 3210 on the common source line 3205, channel structures 3220 penetrating through the gate stack structure 3210, bit lines 3240 electrically connected to the memory channel structures 3220, and contact plugs 3235 electrically connected to the word lines WL (see FIG. 16) of the gate stack structure 3210. As described in the aforementioned example embodiment with reference to FIGS. 1 to 7, the first horizontal conductive layer 102 included in the source structure SS in each of the semiconductor chips 2200 may extend to a region below the separation region MS to vertically overlap the separation region MS.

Each of the semiconductor chips 2200 may include a through interconnection 3245 electrically connected to the peripheral interconnections 3110 of the first semiconductor structure 3100 and extending into the second semiconductor structure 3200. The through interconnection 3245 may be disposed to penetrate through the gate stack structure 3210 and may be on an external side of the gate stack structure 3210. Each of the semiconductor chips 2200 may further include an input/output connection 3265 electrically connected to peripheral interconnections 3110 of the first semiconductor structure 3100 and extending into the second semiconductor structure 3200 and an input/output pad 2210 electrically connected to the input/output connection 3265.

According to the aforementioned example embodiments, by including a first horizontal conductive layer extending horizontally below the separation region, a semiconductor device having improved reliability and mass productivity may be provided.

By way of summation and review, as a method for increasing data storage capacity of a semiconductor device, a semiconductor device including memory cells arranged three-dimensionally, instead of memory cells arranged two-dimensionally, has been suggested. An example embodiment of the present disclosure is to provide a semiconductor device having improved reliability and mass productivity. An example embodiment of the present disclosure is to provide a data storage system including a semiconductor device having improved reliability and mass productivity.

The term "overlap" or "overlapping" may indicate that a layer is either above or below another layer while being located at least partially in the same area with respect to a reference direction, e.g., a vertical direction. It will be understood that when a layer is referred to as "overlapping"' another layer, it can be directly over or under that layer or one or more intervening layers may be present.

Example embodiments have been disclosed herein, and although specific terms are employed, they are used and are to be interpreted in a generic and descriptive sense only and not for purpose of limitation. In some instances, as would be apparent to one of ordinary skill in the art as of the filing of the present application, features, characteristics, and/or elements described in connection with a particular embodiment may be used singly or in combination with features, characteristics, and/or elements described in connection with other embodiments unless otherwise specifically indicated. Accordingly, it will be understood by those of skill in the art that various changes in form and details may be made without departing from the scope of the present invention as set forth in the following claims.

## Claims

1. A semiconductor device, comprising:
a source structure including a plate layer and first and second horizontal conductive layers stacked in order on the plate layer;
gate electrodes stacked and spaced apart from each other in a first direction perpendicular to an upper surface of the source structure;
a channel structure penetrating through the gate electrodes, extending in the first direction, and including a channel layer in contact with the first horizontal conductive layer; and
a separation region penetrating through the gate electrodes and extending in the first direction and in a second direction perpendicular to the first direction,
wherein the first horizontal conductive layer extends horizontally below the separation region and has a seam overlapping the separation region in the first direction.

2. The semiconductor device as claimed in claim 1, wherein the first horizontal conductive layer has a lower protrusion overlapping the separation region in the first direction, extending from a lower surface of the first horizontal conductive layer, and protruding into the plate layer.

3. The semiconductor device as claimed in claim 2, wherein, in the first horizontal conductive layer, a lower end of the lower protrusion is on a first level, and a lower end region in contact with the channel layer is on a second level, the second level being above the first level in a vertical direction.

4. The semiconductor device as claimed in claim 3, wherein the lower surface of the first horizontal conductive layer between the lower protrusion and the channel structure is on a third level, the third level being above the second level in a vertical direction.

5. The semiconductor device as claimed in claim 2 or 3, wherein a level of a lower end of the lower protrusion of the first horizontal conductive layer is equal to or below a level of a lower end of the channel structure in a vertical direction.

6. The semiconductor device as claimed in any one of claims 1 to 5, wherein the first horizontal conductive layer has an upper curved portion on an upper surface thereof and the upper curved portion is curved downwardly toward the plate layer.

7. The semiconductor device as claimed in any one of claims 1 to 6, wherein the second horizontal conductive layer has an opening overlapping the separation region in the first direction.

8. The semiconductor device as claimed in claim 7, wherein the separation region has a first width on the opening of the second horizontal conductive layer in a third direction perpendicular to the first and second directions and has a second width smaller than the first width within the opening in the third direction.

9. The semiconductor device as claimed in claim 7 or 8, wherein a width of the opening ranges from about 60 nm to about 100 nm.

10. The semiconductor device as claimed in any one of claims 1 to 9, wherein the separation region is bent along an end of the second horizontal conductive layer.

11. The semiconductor device as claimed in any one of claims 1 to 10, wherein, in the first horizontal conductive layer, the seam has a first length in the first direction and has a second length greater than the first length in a horizontal direction perpendicular to the first direction.

12. The semiconductor device as claimed in any one of claims 1 to 11, further comprising:
a source insulating layer extending along a circumference of the seam and exposed through an upper surface of the first horizontal conductive layer.

13. The semiconductor device as claimed in claim 12, wherein the source insulating layer has a shape protruding into the separation region from the upper surface of the first horizontal conductive layer.

14. The semiconductor device as claimed in any one of claims 1 to 13, further comprising:
a peripheral circuit structure below the source structure and including a substrate and circuit devices on the substrate.

15. A data storage system, comprising:
a semiconductor storage device including the semiconductor device as claimed in any one of claims 1 to 14, circuit devices, and input/output pads electrically connected to the circuit devices; and
a controller electrically connected to the semiconductor storage device through the input/output pad and configured to control the semiconductor storage device.
